# FASCICULE DE BREVET EUROPEEN

(11) **EP 3 505 813 B1**
(45) Date de publication et mention de la délivrance du brevet: **12.04.2023**
(21) Numéro de dépôt: 18211827.3
(22) Date de dépôt: 12.12.2018
(51) Int. Cl.: F21S 41/141, G02B 19/00, F21S 41/16, G02B 3/00, G02B 26/10, F21S 41/176, H01S 5/00

(54) **MODULE LUMINEUX À BALAYAGE DE FAISCEAU LUMINEUX, NOTAMMENT POUR VÉHICULE AUTOMOBILE, MUNI D'UN SYSTÈME DE FOCALISATION À DIMENSION RÉDUITE, ET DISPOSITIF LUMINEUX DE VÉHICULE AUTOMOBILE COMPORTANT UN TEL MODULE LUMINEUX**
LEUCHTMODUL ZUM SCHWENKEN DES LICHSTRAHLS, INSBESONDERE FÜR KRAFTFAHRZEUG, DAS MIT EINEM FOKALISIERUNGSSYSTEM REDUZIERTER GRÖSSE AUSGESTATTET IST, UND LEUCHTVORRICHTUNG EINES KRAFTFAHRZEUGS, DIE EIN SOLCHES LEUCHTMODUL UMFASST
LIGHT MODULE WITH SCANNING OF LIGHT BEAM, IN PARTICULAR FOR A MOTOR VEHICLE, PROVIDED WITH A REDUCED DIMENSION FOCUSING SYSTEM, AND LIGHTING DEVICE FOR A MOTOR VEHICLE COMPRISING SUCH A LIGHT MODULE

(30) Priorité: 22.12.2017 FR 1763178
(43) Date de publication de la demande: 03.07.2019
(73) Titulaire: Valeo Vision, 93012 Bobigny Cedex (FR)
(72) Inventeur: ALBOU, Pierre, 93012 BOBIGNY Cedex (FR)
(74) Mandataire: Valeo Visibility

(56) Documents cités:
- EP-A1- 2 963 476
- EP-A1- 3 203 305

## Description

La présente invention concerne un module lumineux à balayage de faisceau lumineux, notamment pour véhicule automobile, muni d'un système de focalisation à dimension réduite. L'invention se rapporte également à un dispositif lumineux de véhicule automobile comportant un tel module lumineux.

Les projecteurs de véhicule automobile sont munis d'un ou de plusieurs module lumineux agencés dans un boîtier fermé par une glace de manière à obtenir un ou plusieurs faisceaux d'éclairage et/ou de signalisation à la sortie du projecteur. Il en va de même pour les feux arrières. De façon simplifiée, un module lumineux du boîtier comprend notamment une source de lumière, par exemple une (ou plusieurs) diode(s) électroluminescente(s), qui émet un faisceau lumineux, un système optique de projection du faisceau d'éclairage et/ou de signalisation comportant une ou plusieurs lentilles et, le cas échéant un élément optique, par exemple un réflecteur, pour orienter les rayons lumineux issus des sources lumineuses, afin de former le faisceau lumineux de sortie du module optique.

Dans le monde de l'automobile, les constructeurs et équipementiers automobiles recherchent continuellement à améliorer les performances et la sécurité du véhicule par des innovations techniques. Ainsi, on incorpore dans ces véhicules, des éléments techniques nouveaux qui apportent des avantages spécifiques. Par exemple, dans le cas des modules lumineux pour dispositifs lumineux de véhicules tels que les projecteurs ou les feux arrières, il existe des diodes lasers qui peuvent avantageusement remplacer les diodes électroluminescentes pour produire le faisceau lumineux qui servira à former le faisceau d'éclairage et/ou de signalisation de sortie.

Cependant, les faisceaux lasers usuels sont d'une couleur qui ne correspond pas aux couleurs réglementaires de tels dispositif lumineuxs. Le module lumineux comporte alors un élément de conversion de longueur d'onde, qui présente une surface de conversion. L'élément de conversion reçoit le faisceau lumineux de la source laser et en convertie une partie, l'ensemble formant par exemple en lumière blanche, vers le système optique de projection. Ainsi, le faisceau laser n'est pas utilisé directement pour former le faisceau d'éclairage et/ou de signalisation, mais il est d'abord projeté sur l'élément de conversion de longueur d'onde photoluminescent, qui est par exemple de type phosphorescent et/ou fluorescent.

Il est à noter que dans la présente demande, la notion de faisceau lumineux regroupe les faisceaux électromagnétiques visibles et invisibles à l'oeil humain.

Pour illuminer une zone large de l'élément de conversion avec le faisceau lumineux de la source laser, des moyens de balayage sont nécessaires. Le balayage par le faisceau s'effectue d'un bord à l'autre de la zone de l'élément de conversion, et de préférence à une fréquence suffisamment élevée pour que l'oeil humain ne perçoive pas le mouvement et voit un éclairage continu du faisceau d'éclairage produit par le dispositif. L'amplitude de balayage définit le déplacement du faisceau lumineux dans l'espace et donc la taille de la zone d'éclairage sur l'élément de conversion.

Les moyens de balayage connus sont par exemple des éléments de type MEMS (pour « Micro-Electro-Mechanical-Systems » en anglais ou microsystèmes électromécaniques), comprenant un ou des micro-miroirs qui réfléchissent le faisceau laser sur la zone. Ces micro-miroirs sont par exemple animés d'au moins un mouvement rotatif autour d'un axe qui engendre le balayage de la zone selon une première direction. Un second micro-miroir ou un autre mouvement rotatif du premier miroir autour d'un second axe perpendiculaire au premier axe permet de produire un balayage selon deux directions.

Les dimensions de ces éléments engendrent des contraintes de disposition de chacun d'eux dans le module lumineux. En effet, la distance entre les moyens de balayage et l'élément de conversion définit la taille de la zone balayée par le faisceau lumineux, étant donné que l'amplitude de balayage est dépendante de la configuration des moyens de balayage. On cherche de plus à obtenir une taille de largeur du laser spécifique sur l'élément de conversion qu'on appelle cible. L'intersection du faisceau lumineux et de la cible est appelée « spot » (point en anglais). Ainsi, le spot balaye la zone de l'élément de conversion.

En outre, pour des raisons d'efficacité, il est souhaitable d'illuminer la surface du micro-miroir de manière sensiblement complète, tout en évitant que le faisceau ne déborde au-delà des bords du micro-miroir, sous peine de brûler les autres éléments constituant les moyens de balayage et de perdre de l'énergie. Par conséquent, le faisceau lumineux doit être calibré pour adapter sa largeur aux dimensions des micro-miroirs. On entend par « largeur du faisceau lumineux » la plus grande dimension de son intersection avec le plan du micro-miroir.

Pour cela, on peut utiliser un système de focalisation du faisceau lumineux, comprenant par exemple une lentille convergente pour modifier les dimensions du faisceau lumineux et les adapter à celles du ou des micro-miroirs.

En revanche, certains faisceaux laser très utiles dans la production industrielle, par exemple du type multimode, ne sont pas « gaussiens », c'est-à-dire qu'ils engendrent un faisceau qui ne peut pas être modélisé par une distribution gaussienne unique. Ces lasers doivent être modélisés par une source surfacique de forme sensiblement rectangulaire située au « waist » du faisceau avec un premier axe selon lequel la source est étroite et un deuxième axe selon lequel la source est plus large. On appelle « waist » la dimension minimale du faisceau en un point, le faisceau semblant diverger à partir dudit point. On l'appelle encore col ou taille. De plus, selon le premier axe, qui est dit « rapide », le faisceau diverge plus fortement que selon le deuxième axe, qui est dit « lent». Autrement dit, le comportement du faisceau laser en champ proche et en champ lointain, n'est pas le même dans les deux directions. Ainsi, la largeur du faisceau est plus grande dans la direction de l'axe lent que dans la direction de l'axe rapide au niveau de la source lumineuse.

Par conséquent, il n'est pas possible de focaliser correctement avec une lentille de révolution classique un tel faisceau lumineux laser pour l'adapter à la fois aux dimensions du ou des micro-miroirs et obtenir un spot de la taille voulue sur l'élément de conversion.

Dans la suite de la demande, on entend par faisceau selon l'axe lent et/ou selon l'axe rapide, toutes les composantes du faisceau qui sont parallèles à l'axe lent et/ou parallèles à l'axe rapide respectivement.

De plus, il existe des sources de lumière de type laser, qui sont insérées dans des boîtiers et protégées par une glace transparente afin d'être à l'abri des poussières, qui pourraient provoquer leur dysfonctionnement. Ces moyens de protection, notamment la glace, empêchent de disposer un autre élément optique, par exemple un système de focalisation, au plus près de la source de lumière. Ainsi, la taille du faisceau au niveau du premier dioptre de l'élément optique ne peut être réduite autant que désiré. Et la taille du faisceau lumineux ne peut être alors adaptée aux dimensions du micro-mirroir quelle soit le positionnement relatif du micro-mirroir et de la cible par rapport à la source lumineuse.

Le but de l'invention est de remédier à cet inconvénient, et vise à fournir un module lumineux, notamment d'éclairage et/ou de signalisation, à balayage de faisceau lumineux muni d'un système de focalisation capable de modifier la largeur du faisceau lumineux de manière à l'adapter aux dimensions du ou des micro-miroirs à la fois selon le grand axe et selon le petit axe, et qui permette en plus l'utilisation de sources lumineuses munies de moyens de protection.

Pour cela, l'invention est définie dans la revendication indépendante 1. Des modes de réalisation préférés sont définis dans les revendications dépendantes.

Un élément de conversion comprend au moins un matériau luminescent conçu pour absorber au moins une partie d'au moins une lumière d'excitation émise par une source lumineuse et pour convertir au moins une partie de ladite lumière d'excitation absorbée en une lumière d'émission ayant une longueur d'onde différente de celle de la lumière d'excitation. De préférence le matériau lumlinescent utilisé est choisi parmi les composés suivants : Y₃A1₅O₁₂:Ce³⁺ (YAG), (Sr,Ba)₂SiO₄:Eu²⁺, Caₓ(Si,Al)₁₂(O,N)₁₆:Eu²⁺.

Ainsi, la lentille fait converger le faisceau lumineux entier vers les moyens de balayage, c'est-à-dire à la fois selon l'axe rapide et l'axe lent. Cependant, le dioptre d'entrée sensiblement cylindrique permet de modifier davantage la largeur du faisceau selon l'axe rapide pour pouvoir adapter le faisceau selon l'axe lent et l'axe rapide de manière indépendante. Comme le dioptre d'entrée est cylindrique, il n'a d'effet que selon l'axe rapide du faisceau, et peu ou pas sur l'axe lent du faisceau qui sera focalisé par le dioptre de sortie seulement.

Selon un mode de réalisation préféré et avantageux de l'invention, le point d'inversion est plus proche du dioptre de sortie que du dioptre d'entrée.

Ainsi, la taille du faisceau lumineux au niveau du dioptre de sortie qui fait converger le faisceau vers le spot peut être adapté et notamment rendu plus petite que sur la face d'entrée contrainte par les dispositifs de protection. En d'autres termes on obtient un faisceau lumineux au niveau du dioptre de sortie adaptées à la position et à la taille du micro-mirroir et à la position de la cible.

Selon d' autres modes préférés de réalisation de l'invention, qui pourront être pris ensemble ou séparément :
- le dioptre de sortie est convergent selon les axes lent et rapide,
- le dioptre de sortie présente une courbure convexe, c'est-à-dire une puissance optique positive,
- le dioptre de sortie présente une surface courbe biconique,
- la surface courbe biconique présente un premier rayon courbure selon l'axe lent et un deuxième rayon courbure selon l'axe rapide,
- le premier rayon de courbure est plus grand que le deuxième rayon de courbure,
- le dioptre d'entrée présente une courbure convexe selon l'axe rapide, c'est-à-dire une puissance optique positive,
- le dioptre d'entrée est convergent suivant l'axe rapide,
- la courbure du dioptre d'entrée a une portion sensiblement cylindrique dont l'axe est sensiblement parallèle à l'axe lent,
- le dioptre d'entrée est sensiblement plat selon l'axe lent pour éviter de modifier le faisceau lumineux dans cette direction,
   On entend par « sensiblement plat » que l'intersection de la surface de ce dioptre avec un plan perpendiculaire à l'axe rapide, et donc parallèle à l'axe lent, est sensiblement un segment de droite.
- la lentille est disposée sur le chemin optique du faisceau lumineux entre la source de lumière et les moyens de balayage,
- la lentille est une lentille épaisse,
   On entend par « lentille épaisse » que l'épaisseur de la lentille est supérieure ou égale à la plus grande dimension des dioptres d'entrée et de sortie.
- les moyens de balayage sont munis d'un ou deux micro-miroirs mobiles configurés pour balayer la surface de l'élément de conversion avec le faisceau lumineux selon une première direction et/ou une deuxième direction sensiblement perpendiculaire à la première direction,
- la source de lumière comprend au moins un élément émetteur à semiconducteur, notamment une diode électroluminescente, préférentiellement une diode laser,
- le faisceau lumineux généré par la source de lumière est un faisceau laser,
- l'élément de conversion comprend au moins un matériau luminescent,
- le matériau luminescent est phosphorescent et/ou fluorescent,
- le matériau luminescent est présent sur sensiblement toute la surface de l'élément de conversion.

Un mode préféré de réalisation de l' invention se rapporte également à un dispositif lumineux de véhicule automobile comportant un tel module lumineux.

De préférence, il peut aussi comprendre un système de projection. Le système de projection peut comprendre par exemple au moins une lentille et/ou un mirroir.

L'invention sera mieux comprise à la lumière de la description suivante, accompagnée des dessins joints parmi lesquels :
- la figure 1 illustre de façon schématique, une vue en coupe de côté d'un module lumineux selon l'invention,
- la figure 2 illustre de façon schématique, une vue en coupe selon un plan contenant l'axe rapide de la source lumineuse,
- la figure 3 illustre de façon schématique, un dispositif lumineux de véhicule automobile comprenant un module lumineux selon un mode préféré de réalisation de l' invention.

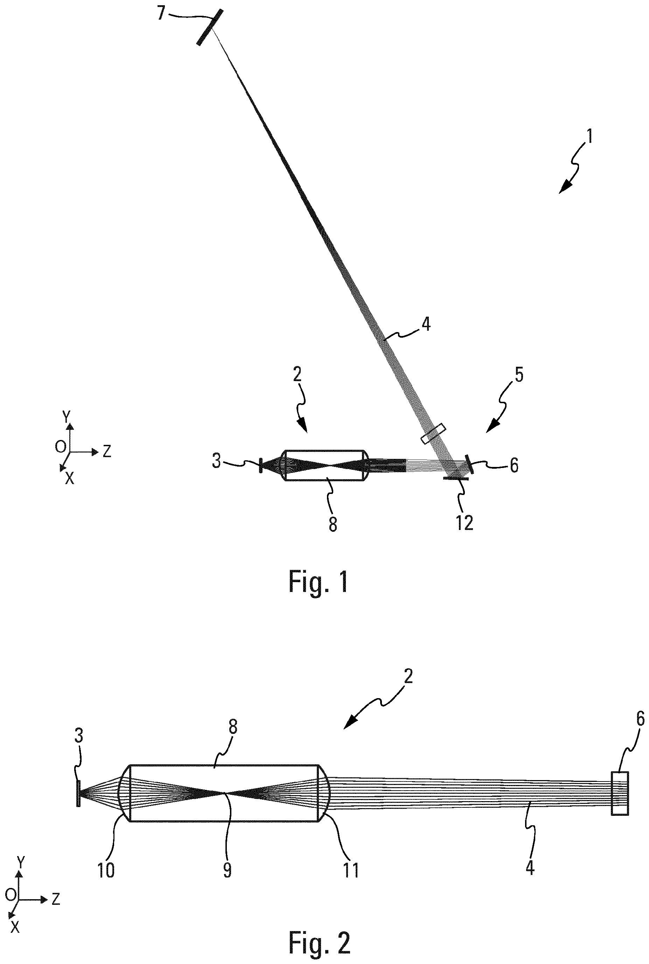

Comme illustré à la figure 1, le module lumineux 1 est, notamment utilisé dans un dispositif lumineux, dans un feu arrière et/ou dans un dispositif d'éclairage intérieur de véhicule automobile, comprend une source 3 de lumière cohérente apte à générer un faisceau de lumière 4 qui présente un axe de propagation selon (Oz), un axe lent selon (Ox) et un axe rapide selon (Oy). Les trois axes sont perpendiculaires deux à deux comme le montre le repère (Oxyz). L'axe lent et l'axe rapide définissent la largeur du faisceau lumineux 4 dans le plan (Oxy) de la source lumineuse, l'axe de propagation étant colinéaire au faisceau lumineux 4. Le faisceau 4 a une forme rectangulaire dans le plan (Oxy) au niveau de la face d'émission de la source lumineuse, la dimension de ce rectangle est plus petite selon l'axe rapide que selon l'axe lent. La source 3 est ici une diode laser qui génère un faisceau laser dont les ondes lumineuses ont sensiblement la même valeur de longueur d'onde, par exemple 448 nm pour obtenir une couleur bleue.

Le module lumineux 1 comprend également un élément de conversion 7 de longueurs d'onde présentant une surface de conversion photoluminescente configurée pour transformer la longueur d'onde du faisceau lumineux, par exemple en étalant la distribution des ondes lumineuses sur des valeurs de longueur d'onde correspondant à des couleurs différentes. Ainsi, on obtient un faisceau dans une autre couleur, par exemple une couleur blanche, à partir du faisceau de lumière initial 4, grâce à l'élément de conversion 7. Le faisceau lumineux blanc sert par exemple de faisceau d'éclairage dans un dispositif lumineux de véhicule automobile. Le faisceau blanc peut donc être obtenue par la synthèse additive d'une partie de la lumière émise par la source lumineuse et d'une partie de la lumière convertie par l'élément de conversion.

Le module lumineux 1 comprend aussi des moyens de balayage 5 de la surface de l'élément de conversion 7 par le faisceau lumineux 4. Les moyens de balayage 5 sont des éléments de type MEMS (pour « Micro-Electro-Mechanical-Systems » en anglais ou microsystèmes électromécaniques), qui comprennent ici deux micro-miroirs 612. Le premier micro-miroir 6 est disposé dans l'axe de propagation du faisceau 4. Le premier micro-miroir 6 réfléchit le faisceau lumineux 4 vers le deuxième micro-miroir 12 qui le réfléchit vers sur la surface de conversion de l'élément de conversion 7. Ces micro-miroirs 6, 12 sont animés d'un mouvement rotatif autour d'un axe qui engendre le balayage de la surface de l'élément de conversion 7 selon une direction chacun. Le balayage par le faisceau 4 s'effectue sur la totalité d'une zone choisie sur la surface de conversion, à une fréquence suffisamment importante, par exemple 200Hz, pour que l'oeil humain ne perçoive pas le mouvement et voit un éclairage continu du faisceau d'éclairage généré par l'élément de conversion 7. Le module lumineux 1 peut comprendre un boitier de protection de l'ensemble, le boitier comprenant une lame de verre pour laisser sortir le faisceau 4.

Le module lumineux 1 comprend en outre un système de focalisation 2 disposé entre la source de lumière 3 et les moyens de balayage 5 pour focaliser le faisceau lumineux 4, d'une part sur les moyens de balayage 5 de manière à couvrir une grande partie des micro-miroirs 6, 12 en évitant de déborder au-delà de leur surface, et afin d'obtenir une taille de spot souhaitée sur la surface de conversion de l'élément de conversion 7.

Les moyens de balayage 5, l'élément de conversion 7 et le système de focalisation 2 sont disposés de sorte que le faisceau lumineux 4 généré par la source de lumière 3 rencontre d'abord les moyens de balayage 5, puis l'élément de conversion 7.

Selon l'invention, le système de focalisation 2 comprend une lentille 8 convergente munie d'un dioptre d'entrée 10 et un dioptre de sortie 11 du faisceau lumineux 4. La lentille 8 est disposée sur le chemin optique du faisceau lumineux entre la source de lumière et les moyens de balayage 5. Autrement dit, le faisceau lumineux 4 généré par la source lumineuse 3 traverse la lentille 8 avant d'atteindre les moyens de balayage 5. La lentille 8 est disposée de manière coaxiale à l'axe optique du faisceau lumineux selon l'axe Oz, de sorte que le faisceau lumineux 4 traverse la lentille 8 en étant sensiblement centrée.

Comme le montre la figure 2, la lentille 8 est configurée pour faire converger le faisceau lumineux 4 selon l'axe rapide. De plus, la lentille 8 est configurée pour faire converger le faisceau lumineux 4 selon l'axe lent. Elle est en particulier prévue pour adapter la largeur du faisceau lumineux 4 à la fois selon l'axe rapide et l'axe lent aux dimensions des moyens de balayage 5, ici au premier miroir 6, ainsi qu'à la taille de spot souhaitée sur l'élément de conversion.

A cette fin, le dioptre d'entrée 10 est sensiblement cylindrique de manière à faire converger le faisceau lumineux 4 selon l'axe rapide jusqu'à induire un point d'inversion 9 de l'image de la source de lumière 3 à l'intérieur de la lentille 8 avant que le faisceau 4 n'atteigne le dioptre de sortie. Autrement dit, le faisceau lumineux 4 converge sur le point d'inversion 9 seulement selon l'axe rapide, la position des bords du faisceau s'inversant selon l'axe rapide après le point d'inversion 9. Le dioptre d'entrée 10 comprend une courbure convexe ayant une portion sensiblement cylindrique dont l'axe est sensiblement parallèle à l'axe lent. Le terme convexe signifie que la courbure du dioptre d'entrée 10 est bombée vers l'extérieur de la lentille, et l'expression « sensiblement cylindrique » signifie que le dioptre a une courbure présentant au moins une portion de cylindre ou proche d'une portion de cylindre. Ici il s'agit d'un cylindre au sens mathématique c'est-à-dire que la section droite du cylindre n'est pas nécessairement circulaire. Ainsi, seule la largeur du faisceau lumineux 4 selon l'axe rapide est modifiée.

Le dioptre d'entrée 10 de la lentille 8 a une focale suffisamment courte pour que le point d'inversion 9 soit dans la lentille 8, c'est-à-dire avant que le faisceau lumineux ne traverse le dioptre de sortie 11, et de façon à obtenir une largeur de faisceau souhaitée sur le dioptre de sortie 11. La largeur souhaitée selon l'axe rapide est choisie en fonction de la focale du dioptre de sortie 11 et de la dimension des moyens de balayage 5 et de leur positionnement par rapport à la lentille et à l'élément de conversion 7. Ainsi, l'image de la source 3 selon l'axe rapide est inversée lorsque le faisceau 4 atteint le dioptre de sortie 11. L'inversion en tant que telle n'a pas de conséquence sur l'utilisation du faisceau lumineux par la suite, car l'image de la source n'a pas de sens particulier ici. En revanche, grâce au positionnement du point d'inversion 9 de l'image de la source aussi près que nécessaire du dioptre de sortie 11, on peut davantage éloigner la lentille 8 de la source 3, que dans le cas d'une lentille dont le dioptre d'entrée n'inverse pas l'image. Ainsi, la lentille 8 permet d'utiliser une source laser munie de moyens de protection. L'effet est lié à l'inversion mais n'en est pas la conséquence ; ce qui est important est l'imagerie à distance finie à l'intérieur de la matière ou encore l'existence du point de convergence 9.

En outre, la largeur du faisceau 4 selon l'axe lent n'est pas modifiée par le dioptre d'entrée de la lentille 8 car le dioptre d'entrée 10 est sensiblement plat selon l'axe lent. Par conséquent, le dioptre d'entrée 10 de la lentille 8 n'est muni que d'une seule courbure afin de ne pas modifier la taille du spot qui sera adaptée par le dioptre de sortie 11.

Le dioptre de sortie 11 de la lentille 8 est convergent selon les axes lent et rapide. A cette fin, le dioptre de sortie 11 présente une courbure convexe. De plus, le dioptre de sortie 11 présente une surface courbe biconique. Autrement dit, la surface du dioptre de sortie 11 a deux rayons de courbures, de préférence un premier pour l'axe lent et un deuxième pour l'axe rapide. Ainsi, la convergence du dioptre de sortie 11 selon chaque axe peut être adaptée séparément.

Ainsi, tel que représenté sur la figure 2, la lentille 8 adapte la largeur du faisceau lumineux 4 selon l'axe rapide aux dimensions du micro-miroir 6 des moyens de balayage 5, grâce à la combinaison des convergences induites par les dioptres d'entrée 10 et de sortie 11.

En outre la lentille 8 est une lentille épaisse afin que le dioptre d'entrée 10 et le dioptre de sortie 11 soient suffisamment éloignés. Le terme « épaisse » signifie qu'il ne s'agit pas d'une lentille mince classique. L'épaisseur de la lentille définit la distance entre le dioptre de sortie 11 et le dioptre d'entrée 10, de sorte qu'on place l'image réelle de la source 3 par rapport à la focale du dioptre de sortie 11 pour obtenir un réglage correct de la largeur du faisceau lumineux selon l'axe rapide. Selon l'axe lent, les dioptres 10 et 11 constituent ensemble une lentille plan-convexe focalisée sur la source et la distance source dioptre d'entrée (choisie aussi petite que possible compte tenu des contraintes imposées par les dispositifs de protection de la source), ajoutée à l'épaisseur de la lentille déterminent pour une distance lentille cible donnée un grandissement ajusté pour obtenir sur la cible un spot de la taille désirée.

Grâce à l'invention, un tel système de focalisation muni d'une lentille 8 épaisse convergente, dont le dioptre d'entrée 10 est cylindrique selon l'axe rapide permet, d'une part d'obtenir une taille de spot conforme à ce que l'on souhaite sur l'élément de conversion 7 dans toutes les directions, et d'autre part d'obtenir uen section du faisceau adaptée aux moyens de balayage 5.

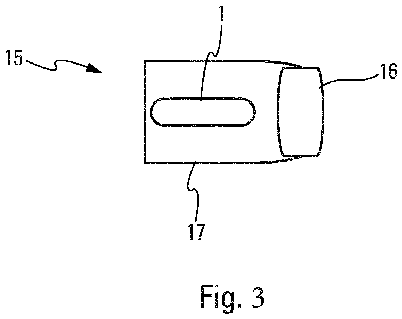

La figure 3 montre par exemple un dispositif lumineux 15 de véhicule automobile muni d'un module lumineux 1 tel que décrit précédemment, le dispositif étant incorporé dans un boîtier 17. Le dispositif lumineux 15 comprend encore un système de projection 16 configuré pour orienter le faisceau lumineux en dehors du dispositif lumineux 15. Le système de projection 16 est par exemple muni d'une lentille de projection placée en aval du module lumineux 1 pour transmettre un faisceau destiné à éclairer la route.

## Revendications

1. Module lumineux d'éclairage (1) à balayage de faisceau lumineux, notamment pour véhicule automobile, comprenant une source de lumière (3) configurée pour générer un faisceau de lumière (4) qui présente un axe lent et un axe rapide, un élément de conversion (7) de longueur d'onde présentant une surface de conversion, et des moyens de balayage (5) agencés pour balayer la surface de conversion avec le faisceau de lumière (4), le module lumineux (1) comprenant en outre un système de focalisation (2) agencé pour focaliser le faisceau lumineux (4) sur l'élément de conversion (7) et pour adapter la largeur du faisceau lumineux (4) aux dimensions des moyens de balayage (5), le système de focalisation (2) comprenant une lentille épaisse (8) convergente selon les axes rapide et lent, la lentille (8) étant munie d'un dioptre d'entrée (10) et un dioptre de sortie (11) du faisceau lumineux (4), **caractérisé en ce que** le dioptre d'entrée (10) est sensiblement cylindrique de manière à faire converger le faisceau lumineux (4) selon l'axe rapide seulement jusqu'à induire un point d'inversion (9) de l'image de la source de lumière (3) à l'intérieur de la lentille (8) avant que le faisceau (4) n'atteigne le dioptre de sortie (11), et **en ce que** le dioptre d'entrée (10) est sensiblement plat selon l'axe lent pour éviter de modifier le faisceau lumineux (4) dans cette direction.

2. Module lumineux selon la revendication 1, dans lequel le dioptre de sortie (11) est convergent selon les axes lent et rapide.

3. Module lumineux selon la revendication 2, dans lequel le dioptre de sortie (11) présente une surface courbe biconique.

4. Module lumineux selon l'une quelconque des revendications précédentes, dans lequel le dioptre d'entrée (10) présente selon l'axe rapide une courbure convexe ayant une portion sensiblement cylindrique dont l'axe est sensiblement parallèle à l'axe lent.

5. Module lumineux selon l'une quelconque des revendications précédentes, dans lequel la lentille (8) est disposée sur le chemin optique du faisceau lumineux (4) entre la source de lumière (3) et les moyens de balayage (5).

6. Module lumineux selon l'une quelconque des revendications précédentes, **caractérisé en ce que** les moyens de balayage (5) sont munis d'un ou deux micro-miroirs mobiles (6, 12) configurés pour balayer la surface de conversion avec le faisceau lumineux (4) selon une première direction et/ou une deuxième direction sensiblement perpendiculaire à la première direction.

7. Module lumineux selon l'une quelconque des revendications précédentes, **caractérisé en ce que** la source de lumière (3) comporte au moins une diode laser, le faisceau lumineux (4) généré étant un faisceau laser.

8. Module lumineux selon l'une quelconque des revendications précédentes, **caractérisé en ce que** l'élément de conversion (7) comprend un matériau phosphorescent.

9. Dispositif lumineux de véhicule automobile comprenant un module lumineux (1) à balayage de faisceau lumineux selon l'une quelconque des revendications précédentes.

10. Dispositif lumineux de véhicule automobile selon la revendication précédente, comprenant en outre un système de projection (16).

## Patentansprüche

1. Beleuchtungslichtmodul (1) mit Lichtstrahlüberstreichung insbesondere für Kraftfahrzeug, das eine Lichtquelle (3), die konfiguriert ist, einen Lichtstrahl (4) zu erzeugen, der eine langsame Achse und eine schnelle Achse aufweist, ein Wellenlängen-Umsetzungselement (7), das eine Umsetzungsoberfläche aufweist, und Überstreichmittel (5), die dafür ausgelegt sind, die Umsetzungsoberfläche mit dem Lichtstrahl (4) zu überstreichen, umfasst, wobei das Lichtmodul (1) außerdem ein Fokussierungssystem (2) umfasst, das dafür ausgelegt ist, den Lichtstrahl (4) auf dem Umsetzungselement (7) zu fokussieren und die Breite des Lichtstahls (4) an die Abmessungen der Überstreichmittel (5) anzupassen, wobei das Fokussierungssystem (2) eine dicke Sammellinse (8) längs der schnellen und der langsamen Achse enthält, wobei die Linse (8) mit einer Eingangslichtbrechungsfläche (10) und mit einer Ausgangslichtbrechungsfläche (11) für den Lichtstrahl (4) versehen ist, **dadurch gekennzeichnet, dass** die Eingangslichtbrechungsfläche (10) im Wesentlichen zylindrisch ist, derart, dass der Lichtstrahl (4) längs der schnellen Achse nur zur Konvergenz gebracht wird, bis ein Umkehrpunkt (9) des Bildes der Lichtquelle (3) in der Linse (8) induziert wird, bevor der Strahl (4) die Ausgangslichtbrechungsfläche (11) erreicht, und dass die Eingangslichtbrechungsfläche (10) längs der langsamen Achse im Wesentlichen flach ist, um eine Veränderung des Lichtstrahls (4) in dieser Richtung zu vermeiden.

2. Lichtmodul nach Anspruch 1, wobei die Ausgangslichtbrechungsfläche (11) längs der langsamen und der schnellen Achse konvergent ist.

3. Lichtmodul nach Anspruch 2, wobei die Ausgangslichtbrechungsfläche (11) eine bikonische gekrümmte Oberfläche aufweist.

4. Lichtmodul nach einem der vorhergehenden Ansprüche, wobei die Eingangslichtbrechungsfläche (10) längs der schnellen Achse eine konvexe Krümmung aufweist, die einen im Wesentlichen zylindrischen Abschnitt besitzt, dessen Achse zu der langsamen Achse im Wesentlichen parallel ist.

5. Lichtmodul nach einem der vorhergehenden Ansprüche, wobei die Linse (8) auf dem optischen Weg des Lichtstrahls (4) zwischen der Lichtquelle (3) und den Überstreichmitteln (5) angeordnet ist.

6. Lichtmodul nach einem der vorhergehenden Ansprüche, **dadurch gekennzeichnet, dass** die Überstreichmittel (5) mit einem oder zwei beweglichen Mikrospiegeln (6, 12) versehen sind, die konfiguriert sind, die Umsetzungsoberfläche mit dem Lichtstrahl (4) in einer ersten Richtung und/oder in einer zu der ersten Richtung im Wesentlichen senkrechten zweiten Richtung zu überstreichen.

7. Lichtmodul nach einem der vorhergehenden Ansprüche, **dadurch gekennzeichnet, dass** die Lichtquelle (3) wenigstens eine Laserdiode enthält, wobei der erzeugte Lichtstrahl (4) ein Laserstrahl ist.

8. Lichtmodul nach einem der vorhergehenden Ansprüche, **dadurch gekennzeichnet, dass** das Umsetzungselement (7) ein phosphoreszierendes Material enthält.

9. Kraftfahrzeug-Lichtvorrichtung, die ein Lichtmodul (1) mit Lichtstrahlüberstreichung nach einem der vorhergehenden Ansprüche enthält.

10. Kraftfahrzeug-Lichtvorrichtung nach dem vorhergehenden Anspruch, die außerdem ein Projektionssystem (16) enthält.

## Claims

1. Lighting light module (1) having light beam scanning, notably for motor vehicles, comprising a light source (3) configured for generating a light beam (4) which has a slow axis and a fast axis, a wavelength conversion element (7) having a conversion surface, and scanning means (5) arranged for scanning the conversion surface with the light beam (4), the light module (1) comprising moreover a focussing system (2) arranged for focussing the light beam (4) onto the conversion element (7) and for adapting the width of the light beam (4) to the dimensions of the scanning means (5), the focussing system (2) comprising a thick lens (8) convergent along the fast and slow axes, the lens (8) being provided with an input dioptre (10) and an output dioptre (11) of the light beam (4), **characterized in that** the input dioptre (10) is substantially cylindrical in such a way as to make the light beam (4) converge only along the fast axis until inducing a point of inversion (9) of the image of the light source (3) inside the lens (8) before the beam (4) reaches the output dioptre (11), and **in that** the input dioptre (10) is substantially flat along the slow axis in order to avoid modifying the light beam (4) **in that** direction.

2. Light module according to Claim 1, **characterized in that** the output dioptre (11) is convergent along the slow and fast axes.

3. Light module according to Claim 2, **characterized in that** the output dioptre (11) has a biconical curve surface.

4. Light module according to any one of the preceding claims, **characterized in that** input dioptre (10) has a convex curvature along the fast axis, having a substantially cylindrical portion whose axis is substantially parallel with the slow axis.

5. Light module according to any one of the preceding claims, **characterized in that** the lens (8) is disposed in the optical path of the light beam (4) between the light source (3) and the scanning means (5) .

6. Light module according to any one of the preceding claims, **characterized in that** the scanning means (5) are provided with one or two mobile micromirrors (6, 12) configured for scanning the conversion surface with the light beam (4) in a first direction and/or in a second direction substantially perpendicular to the first direction.

7. Light module according to any one of the preceding claims, **characterized in that** the light source (3) comprises at least one laser diode, the light beam (4) generated being a laser beam.

8. Light module according to any one of the preceding claims, **characterized in that** the conversion element (7) comprises a phosphorescent material.

9. Motor vehicle light device comprising a light module (1) having light beam scanning according to any one of the preceding claims.

10. Motor vehicle light device according to the preceding claim, comprising moreover a projection system (16).
